# EUROPEAN PATENT APPLICATION

(11) **EP 4 322 202 A1**
(43) Date of publication of application: **14.02.2024**
(21) Application number: 22189588.1
(22) Date of filing: 09.08.2022
(51) Int. Cl.: H01L 21/04, H01L 21/268, H01L 29/45

(54) **METHOD FOR MANUFACTURING A CONTACT ON A SILICON CARBIDE SEMICONDUCTOR SUBSTRATE, AND SILICON CARBIDE SEMICONDUCTOR DEVICE**

(71) Applicant: Infineon Technologies AG, 85579 Neubiberg (DE)
(72) Inventor: JOSHI, Ravi Keshav, 9020 Klagenfurt (AT); MLETSCHNIG, Kristijan Luka, 9500 Villach (AT); KOENIG, Axel, 9500 Villach (AT); LANGER, Gregor, 9061 Klagenfurt (AT)
(74) Representative: Infineon Patent Department

(57) **Abstract**

The disclosure relates to a method for manufacturing a contact on a silicon carbide semiconductor substrate and to a silicon carbide semiconductor device comprising a crystalline silicon carbide semiconductor substrate and a contact layer directly in contact with the silicon carbide semiconductor substrate surface and having, at an interface to the semiconductor substrate, a contact phase portion comprising at least a metal, silicon, and carbon. The method comprises the acts of providing a crystalline silicon carbide semiconductor substrate, depositing a metallic contact material layer onto the crystalline silicon carbide semiconductor substrate, and irradiating at least a part of the silicon carbide semiconductor substrate and at least a part of the metallic contact material layer at their interface with at least one thermal annealing laser beam, thereby generating a contact phase portion at the interface, wherein the contact phase portion comprises at least a metal, silicon, and carbon.

## Description

### TECHNICAL FIELD

The present disclosure generally relates to methods of manufacturing a contact on a silicon carbide semiconductor substrate, and a silicon carbide semiconductor device with an Ohmic contact which, among others, is obtainable by the herein described methods.

### BACKGROUND

Semiconductor devices based on wide bandgap semiconductors, such as silicon carbide (SiC) based diodes or power MOSFETs, are considered as the next generation electronic devices, for example in applications in harsh environments or in the power electronics area. In the development of such semiconductor devices, one aspect is the creation of Ohmic contacts between the semiconductor material and the metal contact or metal layer stack above the semiconductor substrate surface. Especially, the creation of good, reproducible, and homogeneous rear side Ohmic contacts for the SiC substrates is a critical topic.

In the light of the above, there is a need of providing SiC based semiconductor devices having good and homogeneous Ohmic contacts, especially at the rear side of the semiconductor substrate, and providing methods offering large process windows as well as an easy way of manufacturing.

### SUMMARY

Some embodiments relate to a method for manufacturing a contact on a silicon carbide semiconductor substrate, wherein the method may comprise providing a crystalline silicon carbide semiconductor substrate, depositing a metallic contact material layer onto the crystalline silicon carbide semiconductor substrate, and irradiating at least a part of the silicon carbide semiconductor substrate and at least a part of the metallic contact material layer at their interface with at least one thermal annealing laser beam, thereby generating a contact phase portion at the interface. The contact phase portion may comprise at least a metal, silicon, and carbon. Typically, the metal is the same as used in the metallic contact material layer.

The silicon carbide semiconductor substrate may be a monocrystalline substrate. For example, hexagonal polytypes, such as 4H-SiC and/or 6H-SiC crystalline polytypes, may be used. However, the substrate may also comprise regions of a different polytype, e.g. 3C-SiC. In the following description, 4H-SiC is used for explaining the technical effects of the embodiments, while it shall not exclude other polytypes, especially other hexagonal monocrystalline polytypes.

In this specification, the term "on" does mean that a layer or element may be directly on or extended directly onto another layer or element or that intervening layers or elements may be present between the layer or element and said another layer or element. In contrast, when an element is referred to as being "directly on" or extending "directly onto" another element, there are no intervening elements present.

The method as described herein may allow to epitaxially grow a reaction product comprising a metal from the metallic contact material layer and silicon as well as carbon from the SiC semiconductor substrate on the silicon carbide semiconductor substrate. The reaction product may be grown without any lattice mismatch in at least parts of the metallic material layer and the SiC semiconductor substrate near the interface between these two layers. The irradiated area may depend on the lateral dimensions or geometry of the laser shot used for the irradiation. Adjusting the irradiated area by selecting specific irradiation regimens allows to provide the contact phase portions at discrete parts of the interface or all over the whole extension of the interface.

The contact phase portion allows to offer a good Ohmic contact of the metallic contact material to silicon carbide. With proper choice of the metal, it is possible to replace current nickel-based systems in which a nickel silicide layer is formed by laser thermal annealing (LTA). Differently to the nickel silicide formation, in which carbon as by-product may be formed and the adhesion of the contact material layer is weakened, the formation of the contact phase portion including at least a ternary component system allows the generation of Ohmic contacts with good mechanical robustness. In addition, no additional cleaning steps are necessary compared to the nickel silicide-based contacting methods, thus increasing the overall yield of the obtained products.

Generally, the methods described herein provide a large process window as well as an easy way of manufacturing as will be described herein later with reference to some further embodiments and examples.

Further embodiments relate to a silicon carbide semiconductor device comprising a crystalline silicon carbide semiconductor substrate and a contact layer directly in contact with the silicon carbide semiconductor substrate surface. The contact layer has a contact phase portion comprising at least a metal, silicon, and carbon at the interface to the semiconductor substrate. The contact phase portion may be obtained in line with the methods as described herein at least at most parts of the interface between the contact layer and the semiconductor phase. In some embodiments, the contact layer may be grown without any lattice mismatch in at least parts of the metallic material layer and the SiC semiconductor substrate near the interface between these two layers. Therefore, the semiconductor devices may be obtained by one of the methods described herein and may have good and homogeneous Ohmic contacts due to the specific contact phase portions provided.

Of course, the present disclosure is not limited to the above features and advantages. Indeed, those skilled in the art will recognize additional features and advantages upon reading the following detailed description, and upon viewing the accompanying drawings.

### BRIEF DESCRIPTION OF THE DRAWINGS

The elements of the drawings are not necessarily to scale relative to each other. Like reference numerals designate corresponding similar parts. The features of the various illustrated examples can be combined unless they exclude each other. Examples are depicted in the drawings and are detailed in the description which follows.
Figure 1 to 3 illustrates a silicon carbide semiconductor substrate to be provided with an Ohmic contact.
Figure 2 illustrate the semiconductor substrate after deposition of a metallic contact material layer on its surface.
Figure 3 illustrates the semiconductor substrate after irradiation of at least a part of the silicon carbide substrate and at least a part of the metallic contact material layer with a thermal annealing laser beam.
Figure 4 illustrates an exemplary embodiment of a silicon carbide semiconductor device obtained by a method as described herein.
Figure 5 illustrates the contact phase portion of the silicon carbide semiconductor device of Figure 4.
Figure 6 illustrates a further exemplary embodiment of the contact phase portion of the silicon carbide semiconductor device obtainable by the method described herein.

### DETAILED DESCRIPTION

Hereinafter, manufacturing processes for a contact on silicon carbide (SiC) semiconductor substrates, which enable the production of Ohmic contacts in a large process window in an easy way are described in greater detail. The SiC semiconductor substrates generally are silicon carbide work pieces to be processed. For example, the SiC semiconductor substrate may be a SiC based wafer. The SiC semiconductor substrate may, alternatively, comprise a base wafer (also called "growth substrate" or "growth wafer") onto which semiconductor layers are deposited, e.g. by using an epitaxial process. At least one epitaxial layer may adjoin a front side of the SiC semiconductor substrate. In optional process steps, a metal contact layer may be provided on the front side of the SiC semiconductor substrate. In this case, the SiC semiconductor substrate may be a processed wafer. Exemplary processed wafers with a SiC semiconductor substrate may comprise power MOSFETs or diodes. Those SiC based electronic components, usually have an n-doped SiC semiconductor substrate layer at the rear side of the semiconductor substrate to be contacted with a metallic contact layer. However, p-doped SiC semiconductor substrates may also be used. For a p-doped substrate, the doping type of the functional elements may be the opposite doping type as described in the following for n-doped SiC semiconductor substrates. For an n-doped SiC semiconductor substrate, at the front side of the semiconductor substrate, a p-doped semiconductor layer at the interface between the semiconductor substrate and the metallic contact layer may be required for a reliable Ohmic contact. While emphasis is placed on manufacturing methods for Ohmic contacts at power MOSFET or diode component parts, the embodiments and examples described herein are not intended to be limited to these specific electronic components. Instead, the methods can be used for manufacturing Ohmic contacts of any other electronic components based on a SiC semiconductor substrate, for example epitaxial layers comprised by the SiC substrate. Moreover, the term "substrate" may include processed wafers comprising several epitaxial layers in which the growth substrate has been removed before the rear side contact may be generated. In addition, the interface between the semiconductor substrate front and/or rear side and the metal layer may be doped with dopants. For example, n-doped layers at the front side or p-doped layers at the rear side may also be selected depending on the electronic device produced. For each doping type "n" or "p", different doping concentrations can be used. Generally, these concentrations are identified as n- or p+, for example. In this specification, the doping of the substrate is not specifically indicated, but may be implemented in each of the embodiments, if needed.

Even though the method may be used for providing the rear and front side semiconductor substrate surface with Ohmic contacts, typically it is used for providing n-doped rear side contacts. The terms "front side" and "rear side" are used with reference to the orientation in the examples shown in the drawing section. Because components of embodiments can be positioned in a number of different orientations, the directional terminology is used for purposes of illustration only and shall in no way considered to be limiting.

The semiconductor substrate (and, if applicable, the epitaxial layers) provided for manufacturing the Ohmic contact therein typically are crystalline, for example monocrystalline silicon carbide semiconductor substrates. Exemplary embodiments of crystalline semiconductor materials are mostly based on 4H-SiC or 6H-SiC substrates. Thus, the first step usually is providing a crystalline semiconductor substrate, for example a 4H-SiC or 6H-SiC semiconductor substrate. As described above, the semiconductor substrate may comprise device structures within the substrate. Before the step of manufacturing a contact by depositing a metallic material layer and irradiating at least a part of the silicon carbide semiconductor substrate and at least a part of the metallic layer contact material layer at their interface with at least one thermal annealing laser beam, further device structures may be produced within the base substrate.

As described before, the irradiation procedure may allow to generate a contact phase portion at the interface. In some embodiments, the contact phase portion comprises at least a metal, silicon, and carbon. During the irradiation with a thermal annealing laser beam, at least parts of the metallic contact material layer and at least parts of the SiC semiconductor substrate are locally heated such that the crystalline structures are at least partly decomposed. During the cooling down, a reaction product comprising a metal from the metallic contact material layer, and silicon and carbon from the SiC semiconductor substrate may grow epitaxially on the silicon carbide semiconductor substrate. Typically, the obtained contact phase portion may be epitaxially grown without any lattice mismatch in at least parts of the metallic material layer and the SiC semiconductor substrate near the interface between these two layers. At least parts may be a portion of the layer comprising a few atomic layers, for example 3 to 30 atomic layers, in its vertical height, that means perpendicular to the substrate extension, or the generation of grain sections of 3-30 nm height, which then can be arranged in a layer of several grains with partially same and partially different crystallographic orientation with respect to the SiC semiconductor substrate crystallographic orientation. The grown reaction product may be poly-crystalline in nature but every grain may be epitaxially grown on SiC, that means that there may be no crystal mismatch with the SiC substrate. In some embodiments, the reaction product can also be pure TiC having same properties such as an epitaxially grown film thereof. Depending on the irradiated area, which may depend on the lateral dimensions or geometry of the laser shot used for the irradiation, it is possible to provide those contact phase portions at discrete parts of the interface or all over the whole extension of the interface.

The contact phase portion allows to offer a good Ohmic contact of the metallic contact material to silicon carbide even if no nickel silicidation reaction (NiSi formation) is carried out. Unlike to the NiSi system in which carbon sometimes is expelled out to form a graphitic carbon layer on top of NiSi, there is substantially no by-product or a limited number of by-products such as carbon present in the contact phase portion when the contact is manufactured on a silicon carbide semiconductor substrate in line with the methods described herein. Therefore, the methods typically neither have an adverse effect on the further processing of the substrates nor require any post process cleaning steps. In summary, from the mechanical as well as from the electrical point of view, the contact phase portion comprising at least a metal, carbon, and silicon features a robust system in contrast to current NiSi based systems for providing Ohmic contacts on SiC-based substrates. Generally, the methods provide large process windows as well as an easy way of manufacturing as will be described herein later with reference to some further embodiments and examples.

In systems with titanium as metallic contact material, for example, in a thickness of about 10 to 100 nm, exemplified thermal annealing procedures may comprise the use of laser beams having an energy of about 3 to 5 J/cm². Higher thicknesses of the metal layer may need higher energy regimens in order to form grains of crystallites comprising titanium, silicon, and carbon. In case two or more subsequent laser pulses are applied at the same location, lower energy densities may be sufficient to form the crystallites. In case other metals are used as contact material, different energy densities and thicknesses may be applied. In order to produce an Ohmic contact at least part of the crystallites shall grow in an epitaxial manner on the silicon carbide semiconductor substrate near the interface of the metallic contact material layer and the semiconductor substrate.

In an embodiment, the method of manufacturing a contact on a SiC semiconductor substrate may generate a contact phase portion comprising a ternary phase of a metal, silicon, and carbon. Ternary phase may be any three-component phase system including crystalline, such as monocrystalline or polycrystalline, phases comprising a metal, silicon, and carbon, wherein the metal is based on the metallic contact material deposited on the semiconductor substrate. The ratio of metal to silicon to carbon may be varied in these ternary phases depending on the irradiation regimen used.

Exemplified metallic components for the metallic contact material layer comprises a metal, metal silicide, metal carbide, or ternary phase comprising metal, silicon, and carbon. Exemplified metals are such metals that easily may form silicides and/or carbides. In some examples, the metal may be a transition metal. The transition metal may be selected of the group of titanium (Ti), molybdenum (Mo), zirconium (Zr), niobium (Nb), hafnium (Hf), tantalum (Ta), vanadium (V), chromium (Cr), tungsten (W), and any mixtures thereof. All of these may generate stable ternary phases with silicon and carbon having chemical and physical properties which may be suitable for establishing good contact materials for SiC-based semiconductor devices.

In some embodiments, the contact phase portion at the interface may be a crystalline phase mixed of two components of the three-component system while the third component is intercalated. Alternatively, it may be a crystalline phase comprising all three components. The stoichiometry as well as the crystal structure highly depend on the content of each of the three components present in the ternary phase.

In some embodiments, the contact phase portion at the interface may comprise grains, wherein at least a part of these grains may comprise a crystal structure, for example a hexagonal crystal structure, and having a lattice constant being similar or identical to the lattice constant of the silicon carbide semiconductor substrate. Similar lattice constants may include a deviation from the identical lattice constant but allowing an epitaxial growth on the crystal lattice of the silicon carbide semiconductor substrate. More particularly, not all grains are grown strictly epitaxially as they typically are not a continuous crystal. For example, the grains may be discontinuous hexagonal grains of different orientation, which might contain non-hexagonal structures. However, at least a part of the grains may be epitaxially grown on the semiconductor substrate as the ternary phase may have the same or comparable lattice parameters as the crystalline SiC semiconductor substrate material. Exemplified ternary phases having a hexagonal crystal structure may be characterized as Mₙ₊₁AXₙ phases (also called MAX phases), wherein M is a metal or transition metal, A is a metalloid, for example silicon, and X is carbon. Examples of such MAX phases having lattice parameters similar to hexagonal SiC are Ti₃SiC₂, Ti₂SiC, or Mo₃SiC₂.

In some embodiments, the contact phase portion may comprise a layer of grains, wherein most of the grains have a hexagonal crystal structure and at least a part of them have a lattice constant similar or identical to the lattice constant of the crystalline silicon carbide semiconductor substrate, that means may epitaxially be oriented to a crystal lattice of the crystalline silicon carbide semiconductor substrate, at the interface between the contact phase portion and the semiconductor substrate. More particularly, it is assumed that the grains being epitaxially oriented to the crystal lattice of the SiC semiconductor substrate provide a reduced contact resistance if they are arranged directly at the interface or at least close to the interface. Thus, good Ohmic contacts may be obtained at least at these portions. If, for example, a regular network of such grains is provided at the rear-side of the semiconductor substrate, the whole rear side contact may be Ohmic.

In further embodiments, the metallic contact phase portion may comprise at least one further layer of grains mostly having a hexagonal crystal structure comprising at least the metal, silicon, and carbon in a different stoichiometric ratio than the layer of grains at the interface. Thus, a Si-rich or Si-poor ternary phase may be additionally generated within the contact phase portion. In some examples, a silicon-rich matrix may be generated in which grains of the above-described ternary phase or silicon carbide crystallites with reduced content of silicon may be embedded. In this case, the thickness of the layer of grains and/or the thickness of the further layer of grains may be larger than the former metal layer deposited onto the silicon carbide semiconductor substrate due to the decomposition of surface-near parts of the crystal structure of the silicon carbide semiconductor substrate at the interface. With increased LTA fluence, the phase with grains having a ternary phase which is close to the interface may increase, for example from 10 nm to 17-18 nm. Exemplified thicknesses of the further layer of grains may be in the range of about 40 to 70 nm, in particular, about 50 to 60 nm in case the former metal layer was about 40 nm, for example. In case the thickness of the deposited metal layer is smaller or larger than the 40 nm, other thicknesses of the layer of grains with ternary phase or of the further layer with grains may be obtained. In any case, the fluence of LTA and the generation of the specific grains may enhance the Ohmic contact by improved epitaxial growth of the ternary phase at the interface.

In some embodiments, the obtained contact phase portion comprises layers of transition metal carbide with intercalated layers of silicon similar to so called MAX phases described in the literature as materials with special chemical and physical properties. In some examples, however, the contact phase portion may deviate from the exact stoichiometry as described for these MAX phases and may have a different content, for example, a higher content, of silicon in some grains obtained by irradiation with sufficient energy density. In some examples, the grains mainly consist of a ternary phase in which no transition metal carbide crystalline structure can be observed in the EDX (elemental analysis) or XRD measurements. The grains close to the interface layer may contain the lowest silicon concentration while the grains in the layers extending more into the metallic contact material layer may have a higher content of silicon in the ternary phase. Thus, MAX phases of different order may be contained within the contact phase portion. In such MAX phases typically a different number of transition metal carbide crystal units are stacked or layered. For example, a stack of one or two or three such crystal units are generated before one Si layer is intercalated, thus forming the ternary phase. Thus, depending on the number of stacks of crystal units, the silicon content varies in such ternary phases of the contact phase portions. Alternatively, the crystal units may be seen as being embedded in a Si-rich matrix in different contents so that Si-poor or Si-rich ternary phases of the contact phase portions may be generated or precipitated. In some examples, at least parts of the grains comprise a transition metal carbide crystal structure intercalated with about 0 to 25 % silicon, more particularly, about 5 to 15 % silicon, in particular, about 5 to 7 % silicon.

According to some embodiments, the irradiation with at least one thermal annealing laser beam is adjusted to melt the metallic contact material layer and enable diffusion of metal atoms within the silicon carbide semiconductor substrate at least partially at the interface of the silicon carbide semiconductor substrate and the metallic contact material layer. At least one may mean the application of two or more independently applied laser beams at the same location. A timely overlap of the application of the two or more laser beams may be possible. Alternatively, the two or more laser beams may be applied in sequence with a cooling down of the generated mixed phase at the location of irradiation. Upon irradiation with the at least one laser beam, the metal material reacts with the silicon carbide. Thereby the constituent elements of the semiconductor substrate, that means, silicon and carbon, are consumed by the reaction melt forming a ternary phase of metal, silicon, and carbon. By-products, such as carbon precipitates, as typically obtained by laser thermal annealing of silicon carbide semiconductor substrates may not be generated in this process due to the formation of the ternary phase with the metallic material component. The formation of the ternary phase may be described as a diffusion process of metal atoms within the melted silicon carbide semiconductor substrate components. Melted may mean a decomposition of the silicon carbide crystal structure and silicon carbon bonds, thus enabling the forming of a new crystalline phase, the so-called ternary phase.

In addition, the method may comprise in some embodiments, an additional step for providing the crystalline silicon semiconductor substrate. In addition, a step of thinning or grinding of a silicon carbide semiconductor wafer may be comprised in order to flatten the substrate surface, to bring the substrate into the correct thickness, and to prepare the surface area with a sufficient surface roughness for the subsequent steps. The surface roughness might change the effective laser energy coupling and, thus, shifting the energy density window for creation of the metallic contact material layer accordingly. For example, a higher roughness may require a lower energy density level for a given thickness of the metallic contact layer. Hence, in some examples, the roughness of the semiconductor substrate can be used to adjust the Ohmic contact and, more particularly, may be used to further lower the contact resistance at the interface between the semiconductor substrate and the metallic contact material layer.

In some examples, the method may comprise a cleaning step before depositing the metallic contact layer. For example, the cleaning step may include irradiation with particles, e.g. Argon. The cleaning step may be performed in the same process chamber as the deposition step (so-called in-situ cleaning).

According to some embodiments of the method described herein, at least one further metal layer is deposited on the metallic contact material layer. The at least one further metal layer may be composed of contact materials selected from metals such as titanium, nickel, vanadium, silver, and mixtures thereof. A typical metal contact stack may comprise a titanium contact layer as described before, a mixed nickel vanadium layer, and a silver layer, provided in this order on the semiconductor substrate. Those further metal layers provided above an Ohmic contact may be used for providing better contacts or better bonding properties to the semiconductor devices prepared by these methods.

The methods as described before may be used to prepare silicon carbide semiconductor devices. Accordingly, the silicon carbide semiconductor devices obtainable or obtained with these methods may fall within the herein described products. Some embodiments of silicon carbide semiconductor devices comprise a crystalline silicon carbide semiconductor substrate, and a contact layer directly in contact with the silicon carbide semiconductor substrate surface having a contact phase comprising at least a metal, silicon, and carbon. In these semiconductor devices, good Ohmic contacts may be realized due to the presence of an improved contact phase portion as described herein. The contact phase comprises at least a metal, silicon, and carbon in admixture, more particularly, in a crystalline form providing good Ohmic contact at the interface between the semiconductor substrate surface and the metallic contact material layer.

In some embodiments, the metallic contact phase portion at an interface to the silicon carbide semiconductor substrate comprises grains, wherein at least a part of these grains comprises a crystal structure having a lattice constant similar or identical to the lattice constant of the silicon carbide semiconductor substrate. The crystal structure, in particular a hexagonal crystal structure, may be grown in an epitaxial manner on the semiconductor substrate surface in at least parts of the interface, thereby improving the Ohmic contact at least at these portions. In some examples, the whole substrate surface is provided with an Ohmic contact due to the matching of the lattice constants and/or due to the hexagonal crystal structure at the interface. Thereby, the contact phase portion may comprise grains with different orientation of their hexagonal structures.

Further embodiments of the silicon carbide semiconductor devices have a contact phase portion comprising a layer of grains, wherein most of the grains have a hexagonal crystal structure and at least a part of them have a crystal lattice constant similar or identical to the lattice constant of the crystalline silicon carbide semiconductor substrate at the interface between the metallic contact phase portion and the semiconductor substrate. Typically, the contact phase portion may epitaxially be grown without any lattice mismatch in at least parts of the metallic material layer due to the match in lattice constants and the SiC semiconductor substrate near the interface between these two layers may improve the Ohmic contact. The contact phase portion as described herein allows to offer a good Ohmic contact of the metallic contact material to silicon carbide even if no nickel silicidation reaction (NiSi formation) is carried out. Unlike to the NiSi system in which carbon sometimes is expelled out to form a graphitic carbon layer on top of NiSi, there is substantially no by-product or a limited number of by-products such as carbon precipitates present in the contact phase portion when the contact is manufactured on a silicon carbide semiconductor substrate in line with the methods described herein. In summary, from the mechanical as well as from the electrical point of view, the contact phase portion comprising at least a metal, carbon, and silicon features a robust system in contrast to current NiSi based systems for providing Ohmic contacts on SiC-based substrates.

In some embodiments of the semiconductor devices, the contact phase portion further comprises at least one further layer of grains mostly having a hexagonal crystal structure comprising at least the metal, silicon, and carbon in a different stoichiometric ratio than the layer of grains at the interface. Thus, a Si-rich or Si-poor ternary phase may be additionally provided within the metallic contact phase portion. In some examples, a silicon rich matrix may be comprised in which grains of the above-described ternary phase or silicon carbide crystallites with reduced content of silicon are embedded. In this case, the thickness of the layer of grains and/or the thickness of the further layer of grains may be larger than the former metal layer deposited onto the silicon carbide semiconductor substrate due to the decomposition of surface-near parts of the crystal structure of the silicon carbide semiconductor substrate at the interface. With increased LTA fluence, the phase with grains having a ternary phase which is close to the interface may increase, for example from 10 nm to 17-18 nm. Exemplified thicknesses of the further layer of grains may be in the range of about 40 to 70 nm, in particular, about 50 to 60 nm in case the former metal layer was about 40 nm, for example. In case the thickness of the metal layer is smaller or larger than the 40 nm, other thicknesses of the layer of grains with ternary phase or of the further layer with grains may be present in the semiconductor devices prepared in line with the methods described herein. In any case, the specific crystallite structure and the specific content of the components of the grains may enhance the Ohmic contact by an improved epitaxial match of the ternary phase to the monocrystalline semiconductor substrate at the interface.

In some embodiments, the metallic contact phase portion may comprise layers of a transition metal carbide with intercalated layers of silicon. Those metallic contact phase portions may comprise a structure similar to so-called MAX phases described in the literature as materials with special chemical and physical properties. In some examples, however, the contact phase portion may deviate from the exact stoichiometry as described for these MAX phases and may have a different content, for example, a higher content, of silicon in some grains obtained. In some examples, the grains mainly consist of a ternary phase in which no transition metal carbide crystalline structure can be observed in the EDX (elemental analysis) or XRD measurements. The grains close to the interface layer may contain the lowest silicon concentration while the grains in the layers extending more into the metallic contact material layer may have a higher content of silicon in the ternary phase. Thus, MAX phases of different order may be contained within the contact phase portion. In such MAX phases usually, a different number of transition metal carbide crystal units are stacked or layered, for example one or two or three stacked crystal units, before one Si layer is intercalated into the ternary phase. Thus, depending on the number of stacks of crystal units, the silicon content varies in such ternary phases of the contact phase portions. Alternatively, the crystal units may be seen as being embedded in a Si-rich matrix in different contents so that Si-poor or Si-rich ternary phases of the contact phase portions may be generated or precipitated. In some examples, the layer of grains comprises a transition metal carbide crystal structure intercalated with about 0 to 25 % silicon, more particularly, about 5 to 15 % silicon, in particular, about 5 to 7 % silicon. The transition metal may be titanium, for example.

In some embodiments, the silicon carbide semiconductor device may comprise at least one further metal layer deposited on the metallic contact material layer. This allows to improve the contact and bonding properties of the finished semiconductor device to other device structures in finished products. In some embodiments, the contact layer is provided as rear side contact (sometimes also called backside contact). In further embodiments, the semiconductor substrate may comprise several device structures at the front side surface before the Ohmic contact at the rear side may be manufactured.

The manufacturing methods described herein allow the production of Ohmic contacts in an efficient manner offering large process windows as well as an easy way of manufacturing. As substantially no precipitation of by-products is observed during the manufacturing of the Ohmic contacts, post-processes cleaning steps may not be needed. This increases the overall yield. At the same time, the obtained semiconductor devices offer good mechanical robustness. The thus obtained SiC based semiconductor devices are produced with good and homogeneous Ohmic contacts, especially at the rear side of the semiconductor substrate. Due to the specific ternary phase in the contact phase portion, the Ohmic contact resistance may be lower than in current nickel silicide-based systems, thus reducing the electrical resistance of the semiconductor devices obtainable by the methods described herein.

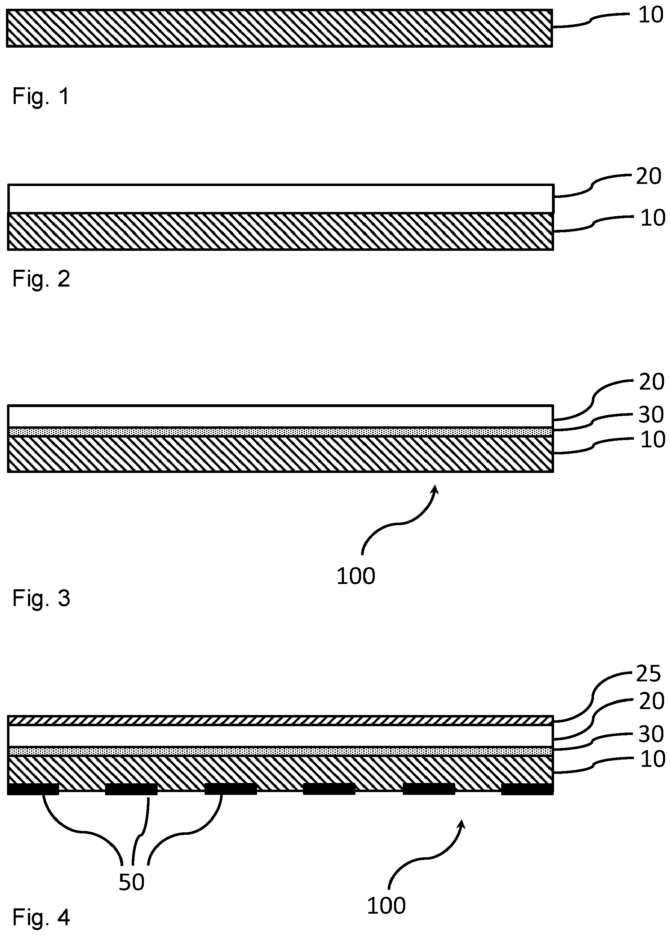

The above-described embodiments will be further described by referring to the drawings which show specific examples of the methods and semiconductor devices obtained therewith. Referring now to Figures 1 to 3, a method of manufacturing an exemplary embodiment of a semiconductor device has been shown. Figure 1 illustrates a cross-sectional view of a SiC semiconductor substrate to be provided with an Ohmic contact. The monocrystalline SiC semiconductor substrate layer 10 may, for example, mainly comprise a 4H-SiC wafer material. As a preparatory step, the wafer may be prepared by a typical thinning technique to provide a polished surface of SiC,

In a further step of the herein described exemplified method, a metallic contact material layer 20 is deposited onto the SiC semiconductor substrate layer 10 as it is shown in Figure 2. For example, a titanium layer may be deposited by a sputtering or chemical vapor deposition technique in a thickness of about 40 nm. Alternative thickness levels may be between about 20 and 150 nm, more particularly, about 20 nm or about 40 nm or about 100 nm.

The metallized SiC surface, that means the interface between the semiconductor substrate layer 10 and the metallic contact material layer 20 deposited thereon, is subjected to laser thermal annealing. The irradiation of at least a part of the SiC semiconductor substrate layer 10 and at least a part of the metallic contact material layer 20 may be carried out by irradiation with an annealing laser beam to generate a reaction between the titanium as metallic material and SiC of the semiconductor substrate. The constituents of the semiconductor substrate, namely Si and C, are consumed by this reaction under high temperature and create a layer comprising a ternary phase of titanium, silicon, and carbon. It was observed that substantially no by-product such as free carbon clusters are generated. A SiC semiconductor device 100 prepared accordingly, is shown in Figure 3. Most of the contact phase portion 30 is composed of the ternary phase comprising at least three components, namely titanium, silicon, and carbon. In some examples, especially, if mixed metallic contact materials are used, a fourth component or additional components may be present in the contact phase portion, thereby forming a mixed phase of four or more components instead of a ternary phase.

In order to generate temperatures high enough to decompose the SiC crystalline structure and form the ternary system with the titanium, the energy density of the laser beam is adjusted accordingly. In some examples, two or more laser pulses may be applied to achieve the melting of the crystal structure and the formation of the ternary phase. Especially, in the system of titanium as metal contact material, an energy density of about 3-5 J/cm² may be sufficient to form Ohmic contacts between the SiC semiconductor substrate 10 and the deposited titanium contact layer 20 in one laser thermal annealing step. Using two laser thermal annealing steps or two subsequent laser beam irradiations, the energy density of each laser beam may be reduced.

Figure 4 illustrates an exemplary embodiment of a silicon carbide semiconductor device 100 obtained by a method as described herein. The crystalline SiC semiconductor substrate 10 may be provided at its front side surface with several device structures 50 previously prepared before a thinning step may be carried out at its rear side. The SiC semiconductor device 100 further comprises a contact phase portion 30, a metallic contact layer 20, and a further metal layer 25 deposited on the rear side of the crystalline SiC semiconductor substrate layer 10. Using a method as described herein, it is possible to produce a good Ohmic contact at the rear side of a crystalline SiC semiconductor substrate without heating the whole wafer. Thus, already prepared device structures 50 likely are not damaged due to excessive heat. As the generation of the ternary contact phase portion at or near the interface to the SiC semiconductor substrate interface is carried out at sufficiently high energy densities, the growth of the ternary TiSiC phase takes place in an epitaxial manner, adopting the lattice parameters of the SiC substrate at least in some parts of the contact phase portion. Thus, the formation of a good Ohmic contact is obtained, even though the contact phase portion does not necessarily match with the Ti₃SiC₂ stoichiometry for a typical MAX phase. Assumingly, the match of the grown crystallites in the contact phase portion significantly reduces the contact resistance to the SiC semiconductor substrate. At the same time, the contact provides a good mechanical robustness and a high reliability.

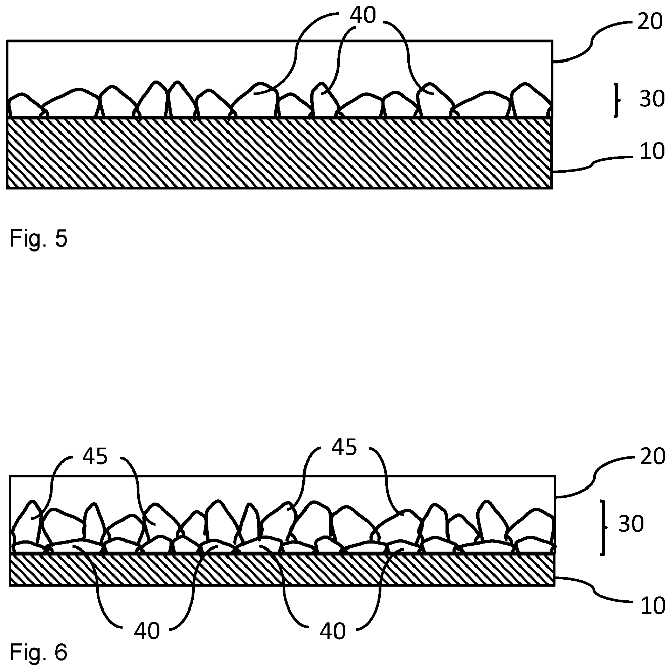

Figure 5 illustrates the contact phase portion of the silicon carbide semiconductor device of Figure 4. In the contact phase portion 30, at least one layer of grains 40 is formed by the irradiation with at least one laser beam with sufficient energy density. Each grain is composed of a ternary TiSiC phase. At least some of the grains 40 at the interface to the SiC semiconductor substrate 10 comprises a crystalline hexagonal structure. In some examples, most of the grains 40 have a hexagonal crystal structure, thus decreasing the contact resistivity and providing good Ohmic contact. In further examples, at least a part of these grains 40 is epitaxially oriented to the crystal lattice of the crystalline SiC semiconductor substrate 10 to further decrease the contact resistance at the interface of the SiC semiconductor substrate 10 and the contact layer 20. The layer of grains is shown in this Figure only schematically. It may comprise grains with different sizes, holes filled with silicon or TiSiC matrix material. It may also comprise stacked layers of several grain layers.

Figure 6 illustrates a further exemplary embodiment of the contact phase portion of the silicon carbide semiconductor device obtainable by the method described herein. As mentioned before, the contact phase portion 30 comprises at least two layers of different grains (40, 45). The first layer of grains 40 may be the same as described with reference to Figure 5. Typically, the thickness of the layer with grains 40 is about 15 to 20 nm, while the thickness of the layer with grains 45 is larger than 20 nm, for example 40 to 60 nm, in particular about 60 nm. The grains 45 of the layer above the first grain layer, that means the grains 45 which are not in direct contact with the SiC semiconductor substrate surface 10 may have a different stoichiometric ratio of titanium, silicon, and carbon than the layer of grains 40 at the interface. By sufficiently adjusting the energy density and having a thickness of the titanium layer of 40 nm, the layer of grains 40 near the interface to the SiC semiconductor substrate surface 10 may be a homogeneous layer of crystal grains of different orientation with an increased content of Ti and C. In some examples a ternary phase summing up to about Ti₇SiC₆ was obtained. In the layer of grains 45, which are not so close to the interface, higher Si contents and less Ti contents compared to the grains 40 were measured in some examples. These contents are exemplified values only, while ideal MAX phases in these systems may have the stoichiometric contents of about Ti₃SiC₂, for example. Nevertheless, the contact resistivity was low so that Ohmic contacts could be generated by these ternary TiSiC phases at the interface between the SiC semiconductor layer 10 and the metallic contact material layer 20.

The above illustrated manufacturing method of a contact on a monocrystalline SiC semiconductor substrate allows the fabrication of a reliable Ohmic contact within a broad process window. Hence, the overall manufacturing process is easier and results in good and homogenous Ohmic contacts and an improved reliability of the obtained SiC semiconductor devices.

Terms such as *"first",* "*second*", and the like, are used to describe various embodiments, layer, order of steps, etc. and are also not intended to be limiting. Like terms refer to like elements throughout the description.

As used herein, the terms "*having*", "*containing*", "*including*", "*comprising*" and the like are open ended terms that indicate the presence of stated elements or features, but do not preclude additional elements or features. The articles "*a*", "*an*" and *"the"* are intended to include the plural as well as the singular, unless the context clearly indicates otherwise.

It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments and examples shown and described without departing from the scope of the present disclosure. This application is intended to cover any adaptations or variations of the specific embodiments discussed herein. Therefore, it is intended that this disclosure be limited only by the claims and the equivalents thereof.

## Claims

1. A method for manufacturing a contact on a silicon carbide semiconductor substrate, wherein the method comprises:
- providing a crystalline silicon carbide semiconductor substrate,
- depositing a metallic contact material layer onto the crystalline silicon carbide semiconductor substrate, and
- irradiating at least a part of the silicon carbide semiconductor substrate and at least a part of the metallic contact material layer at their interface with at least one thermal annealing laser beam, thereby generating a contact phase portion at the interface, wherein the contact phase portion comprises at least a metal, silicon, and carbon.

2. The method according to claim 1, wherein the contact phase portion comprises a ternary phase of the metal, silicon, and carbon.

3. The method according to any of the preceding claims, wherein the metal is a transition metal selected of the group of titanium, molybdenum, zirconium, niobium, hafnium, tantalum, vanadium, chromium, tungsten, and mixtures thereof.

4. The method according to any of the preceding claims, wherein the contact phase portion at the interface comprises grains, wherein at least a part of these grains comprises a crystal structure having a lattice constant similar or identical to the lattice constant of the silicon carbide semiconductor substrate.

5. The method according to any of the preceding claims, wherein the contact phase portion comprises a layer of grains, wherein most of the grains have a hexagonal crystal structure and at least a part of them have a lattice constant similar or identical to the lattice constant of the crystalline silicon carbide semiconductor substrate at the interface between the contact phase portion and the semiconductor substrate.

6. The method according to claim 5, wherein the contact phase portion comprises at least one further layer of grains mostly having a hexagonal crystal structure comprising at least the metal, silicon, and carbon in a different stoichiometric ratio than the layer of grains at the interface.

7. The method according to any of claims 4 to 6, wherein at least parts of the grains comprise a transition metal carbide crystal structure intercalated with 0 to 25 % silicon.

8. The method according to any of the preceding claims, wherein the irradiation with at least one thermal annealing laser beam is adjusted to melt the metallic contact material layer and enable diffusion of metal atoms with the silicon carbide semiconductor substrate at least partially at the interface of the silicon carbide semiconductor substrate and the metallic contact material layer.

9. The method according to any of the preceding claims, wherein providing a crystalline silicon semiconductor substrate comprises a thinning or grinding step of a silicon carbide semiconductor wafer.

10. The method according to any of the preceding claims, wherein at least one further metal layer is deposited on the metallic contact material layer.

11. A silicon carbide semiconductor device, comprising
- a crystalline silicon carbide semiconductor substrate, and
- a contact layer directly in contact with the silicon carbide semiconductor substrate surface and having, at an interface to the semiconductor substrate, a contact phase portion comprising at least a metal, silicon, and carbon.

12. The silicon carbide semiconductor device according to claim 11, wherein the contact phase portion at the interface to the silicon carbide semiconductor substrate comprises grains, wherein at least a part of these grains comprises a crystal structure having a lattice constant similar or identical to the lattice constant of the silicon carbide semiconductor substrate.

13. The silicon carbide semiconductor device according to any of the claims 11 to 12, wherein the contact phase portion comprises a layer of grains, wherein most of the grains have a hexagonal crystal structure and at least a part of them have a lattice constant similar or identical to the lattice constant of the crystalline silicon carbide semiconductor substrate at the interface between the contact phase portion and the semiconductor substrate.

14. The silicon carbide semiconductor device according to claim 13, wherein the contact phase portion further comprises at least one further layer of grains mostly having a hexagonal crystal structure comprising at least the metallic contact material, silicon, and carbon in a different stoichiometric ratio than the layer of grains at the interface.

15. The silicon carbide semiconductor device according to any of claims 12 to 14, wherein at least parts of the grains comprise a transition metal carbide crystal structure intercalated with 0 to 25 % silicon.

16. The silicon carbide semiconductor device according to any of the claims 11 to 15, wherein at least one further metal layer is deposited on the metallic contact material layer.

17. The silicon carbide semiconductor device according to any of claims 11 to 16, wherein the contact layer is provided as rear side contact.

18. The silicon carbide semiconductor device according to claim 17, wherein the semiconductor substrate comprises several device structures at the front side surface.
